# EUROPEAN PATENT SPECIFICATION

(11) **EP 1 655 660 B1**
(45) Date of publication and mention of the grant of the patent: **13.04.2011**
(21) Application number: 03818109.5
(22) Date of filing: 14.08.2003
(51) Int. Cl.: G06F 11/20

(54) **COMPUTER DEVICE AND CLUSTER SERVER DEVICE**
COMPUTEREINRICHTUNG UND CLUSTER-SERVER-EINRICHTUNG
DISPOSITIF INFORMATIQUE ET DISPOSITIF DE SERVEUR DE GRAPPE

(43) Date of publication of application: 10.05.2006
(73) Proprietor: FUJITSU LIMITED, Kawasaki-shi, Kanagawa 211-8588 (JP)
(72) Inventor: NIIGATA, Katsuya Fujitsu Limited, Kanagawa 211-8588 (JP)
(74) Representative: Körfer, Thomas
(86) International application number: PCT/JP2003/010343
(87) International publication number: WO 2005/017734

(56) References cited:
- JP-A- 5 334 006
- US-B1- 6 325 636
- "PHOENIX BLADE SERVER 318 SERIES" INTERNET CITATION, [Online] June 2002 (2002-06), XP002292979 Retrieved from the Internet: URL:http://www.phoenixdatacom.com/pbs318_3 20_brochure.pdf> [retrieved on 2004-08-18]
- HONJO Y. ET AL.: 'IA server: PRIMERGY, FUJITSU' vol. 53, no. 6, 08 November 2001, pages 463 - 470, XP002984914

## Description

### TECHNICAL FIELD

The present invention relates to a computer device such as a cluster-type server device in which a plurality of information processing units are mounted, and a cluster server device, and more particularly relates to a computer device and a cluster server device that can hot-swap a storage device having a redundant configuration, in a plurality of information processing units.

### BACKGROUND ART

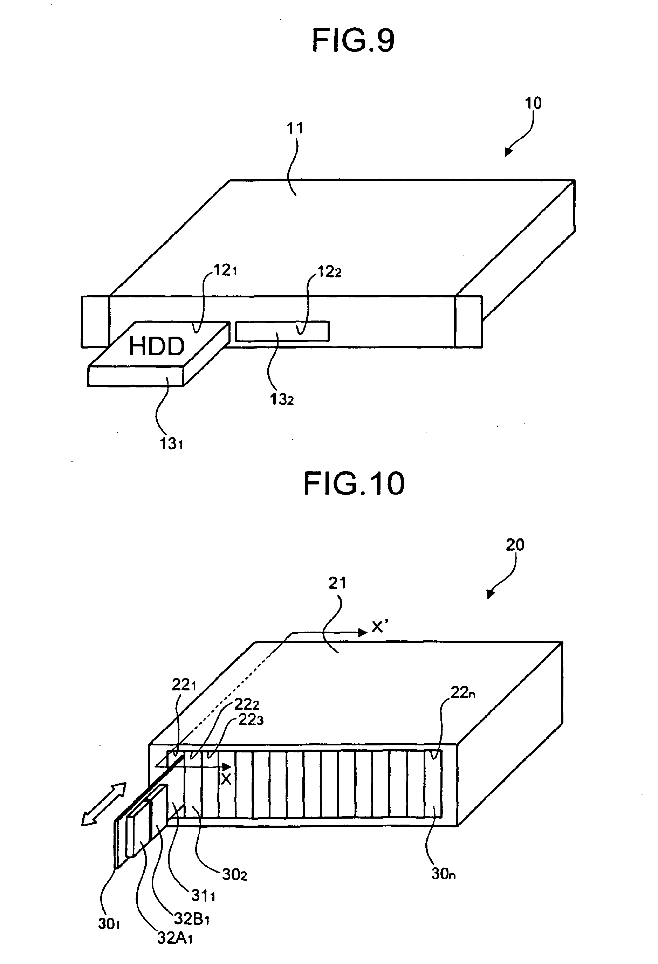

Fig. 9 is a perspective view of an external configuration of a conventional computer device 10. The computer device 10 is, for example, a server device including a central processing unit (CPU) (not shown), a hard disk controller (HDD), and the like, provided inside a casing 11.

Two slots 12₁ and 12₂ are formed in a front face of the casing 11. Hard disks (HDD) 13₁ and 13₂ are removably inserted into the slots 12₁ and 12₂.

The HDD controller controls writing to and reading from the HDDs 13₁ and 13₂, which are large-capacity storage devices that store various types of data handled by the CPU. The HDDs 13₁ and 13₂ are arranged in a redundant configuration.

A mirror ring is used to store identical data in the HDDs 13₁ and 13₂, so that one can be used for recovery if the other breaks down.

The computer device 10 also includes a function of, when one of the HDDs 13₁ and 13₂ breaks down, replacing the broken HDD without terminating the operation of the computer device 10 (hot-swap).

If the HDD 13₁ breaks down, data is recovered from the HDD 13₂. The broken HDD 13₁ is removed from the slot 12₁ without terminating the operation of the computer device 10, and a replacement HDD (not shown) is inserted into the slot 12₁.

Fig. 10 is a perspective view of an external configuration of a conventional computer device 20. The computer device 20 is a cluster server device (blade server device) in which a plurality of card-type information processing units 30₁ to 30ₙ can be inserted into a casing 21. Each of the information processing units 30₁ to 30ₙ has the same functions as the computer device 10 (see Fig. 9) .

'n' number of slots 22₁ to 22ₙ are formed in a front face of the casing 21. The information processing units 30₁ to 30ₙ are removably inserted into the slots 22₁ to 22ₙ.

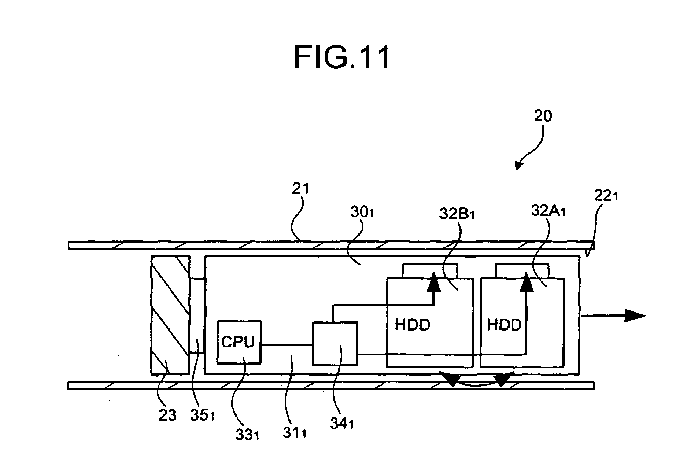

Fig. 11 is a cross section taken along line X-X' of Fig. 10. In Fig. 11, like reference numerals designate like parts as those shown in Fig. 10. In Fig. 11, a back plane 23 is provided inside the casing 21, and is physically and electrically connected to the information processing units 30₁ to 30ₙ (see Fig. 10). The back plane 23 supplies electrical power to the information processing units 30₁ to 30ₙ, and has a function of providing an interface.

The information processing unit 30₁ consists of a card-shaped printed circuit board 31₁, an HDD 32A₁, an HDD 32B₁, a CPU 33₁, and an HDD controller 34₁, and includes the same server functions as the computer device 10, as mentioned already.

The HDD 32A₁, the HDD 32B₁, the CPU 33₁, and the HDD controller 34₁ are mounted on the printed circuit board 31₁. The information processing unit 30₁ is mounted on the back plane 23 via a connector 35₁.

The HDD controller 34₁ controls writing to and reading from the HDD 32A₁ and the HDD 32B₁, which are large-capacity storage devices that store various types of data handled by the CPU 33₁. The HDD 32A₁ and the HDD 32B₁ are arranged in a redundant configuration.

A mirror ring is used to store identical data in the HDDs 32A₁ and 32B₁, so that one can be used for recovery if the other breaks down. Therefore, if the HDD 32A₁ breaks down, data is recovered from the HDD 32B₁.
Patent Document 1: Japanese Patent Application Laid-Open No. H11-184643

In the conventional computer device 20 (Figs. 10 and 11), the HDD 32A₁ and the HDD 32B₁ in the information processing unit 30₁ shown in Fig. 11 have a redundant configuration. However, although data can be recovered from one of the HDDs if the other breaks down, there is a problem that the broken HDD cannot be hot-swapped.

The HDD 32A₁ and the HDD 32B₁ are mounted on the same printed circuit board 31₁. Threfore, to replace the broken HDD 32A₁, the entire printed circuit board 31₁ must be removed from the back plane 23, and the operation of the information processing unit 30₁ (server) must be terminated, while the broken HDD 32A₁ is replaced with a replacement HDD. The information processing unit 30₁ must then be remounted on the back plane 23.

Document US 6,325,636 B1 discloses a server chassis comprising processing cards. Such a processing card provides the functionality of a single board computer and amongst other components comprises a central processing unit CPU and a dynamic memory integrated circuit. The server chassis is further described as "hot swappable" since each web server processing card can be replaced from within the chassis while the chassis is powered on.

Document US 2002/0194412 A1 discloses a modular server system where up to sixteen independent server blades and up to sixteen media blades can be provided. A server blade is paired up with a media blade, so that the combination becomes an independent server within the modular server system. The media blade can have two or more hard disc drives and may provide a Redundant Array of Independent Discs (RAID) functionality.

The present invention has been achieved in view of the above problems, and it is an object of the present invention to provide a computer device that can hot-swap a storage device having a redundant configuration, in a plurality of information processing units.

This object is achieved by a computer device as defined in independent claim 1.

Advantageous features and embodiments are subject matter of the dependent claims.

### BRIEF DESCRIPTION OF DRAWINGS

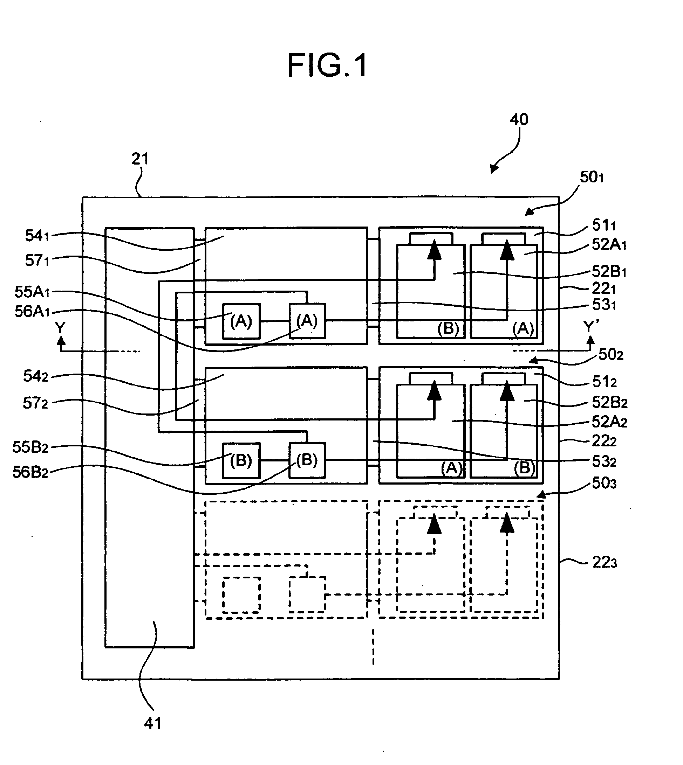

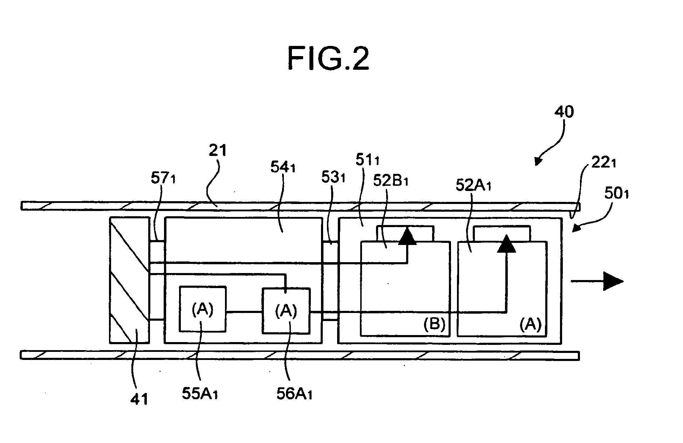

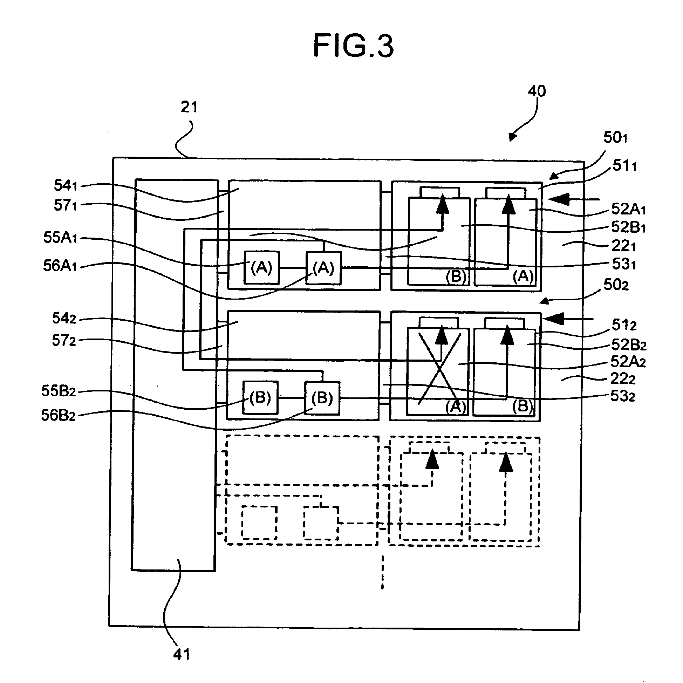

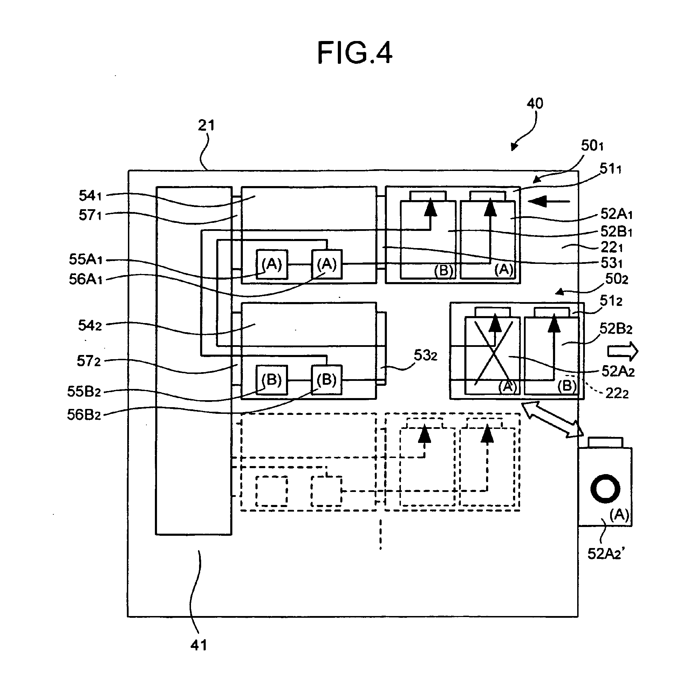

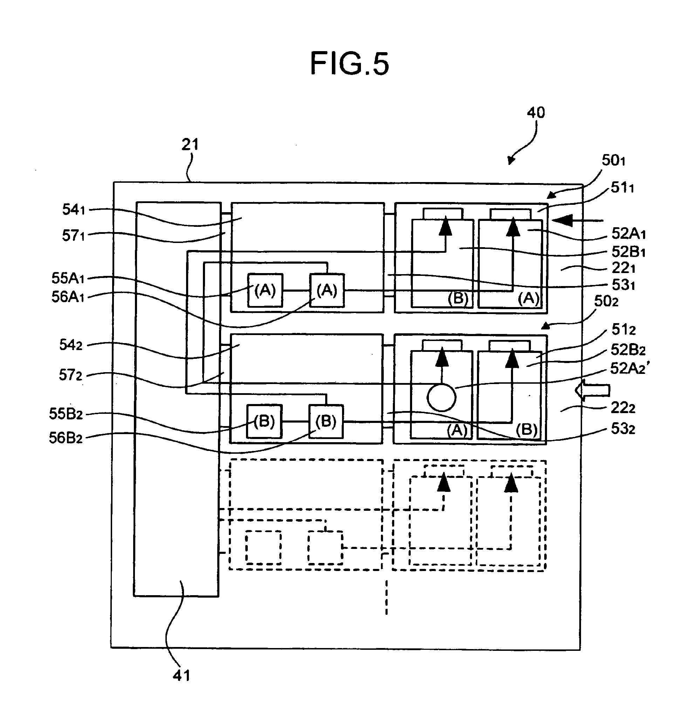

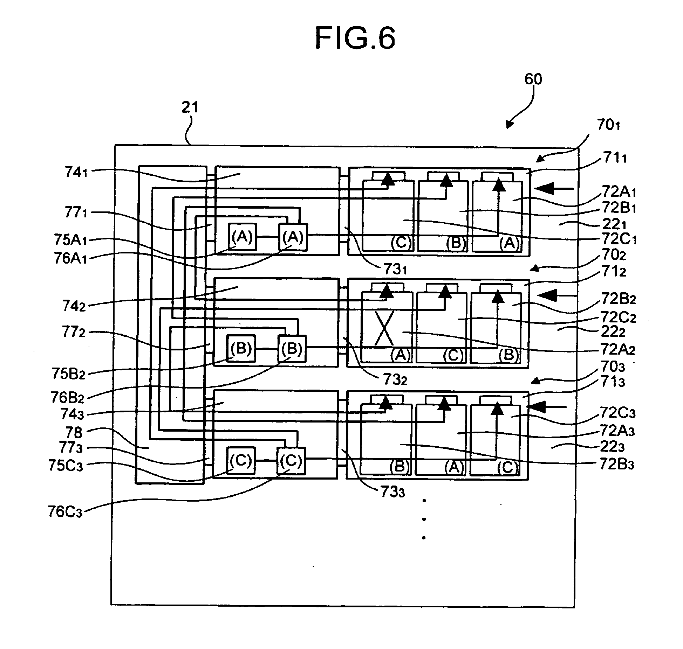

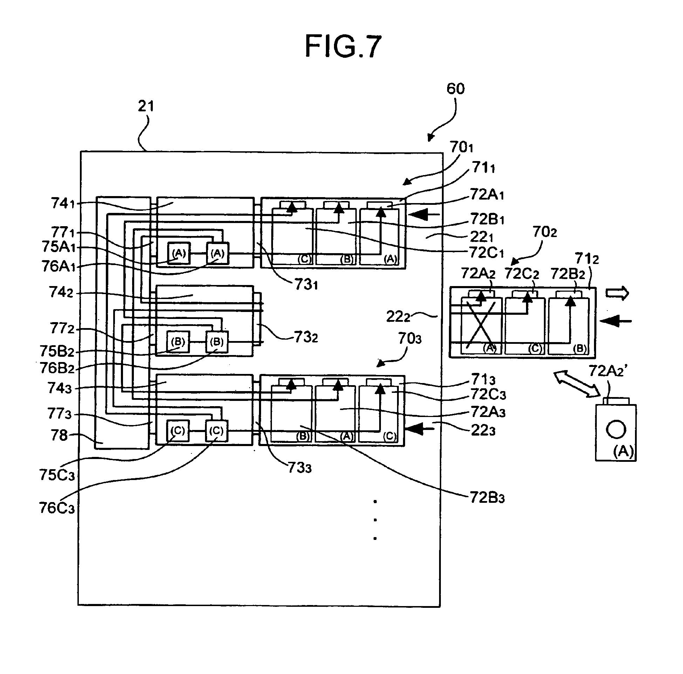

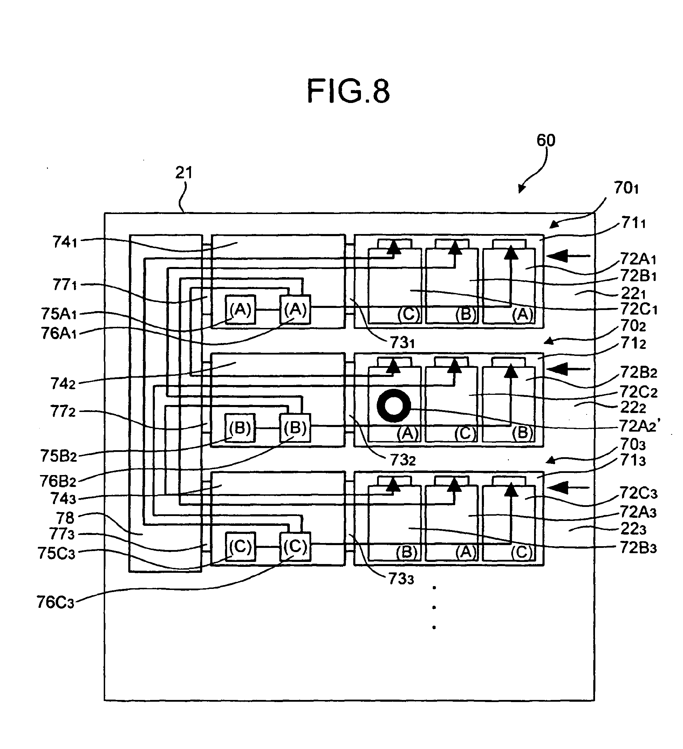

Fig. 1 is a schematic plan view of a configuration according to a first embodiment of the present invention, Fig. 2 is a cross section taken along line Y-Y' of Fig. 1, Fig. 3 is a diagram to explain a hot-swap method according to the first embodiment, Fig. 4 is another diagram to explain the hot-swap method according to the first embodiment, Fig. 5 is still another diagram to explain the hot-swap method according to the first embodiment, Fig. 6 is a schematic plan view of a configuration according to a second embodiment of the present invention, Fig. 7 is a diagram to explain a hot-swap method according to the second embodiment, Fig. 8 is an explanatory diagram of the hot-swap method according to the second embodiment, Fig. 9 is a perspective view of an external configuration of a conventional computer device 10, Fig. 10 is a perspective view of the external configuration of a conventional computer device 20, and Fig. 11 is a cross section taken along line X-X' of Fig. 10.

### BEST MODE(S) FOR CARRYING OUT THE INVENTION

Exemplary embodiments of the present invention will be explained in detail below with reference to the accompanying drawings.
Fig. 1 is a schematic plan view of a configuration according to a first embodiment of the present invention. Fig. 2 is a cross section taken along line Y-Y' of Fig. 1. In Figs. 1 and 2, like reference numerals designate like parts as those shown in Figs. 10 and 11.

A computer device 40 shown in Fig. 1 is a cluster server device (blade server device) in which a plurality of information processing units 50₁, 50₂, 50₃, ... can be provided in the casing 21.

In Fig. 1, although the information processing units 50₁, 50₂, 50₃, ... are provided vertically in the same manner as the information processing units 30₁, 30₂, ... shown in Fig. 10, they are depicted in a plan view in the drawing.

The information processing units 50₁, 50₂, 50₃, ... can be freely inserted into and removed from slots 22₁, 22₂, 22₃, ... in the casing 21.

A back plane 41 is provided inside the casing 21, and is physically and electrically connected to the information processing units 50₁, 50₂, ... via connectors 57₁, 57₂, ... (see Fig. 2). The back plane 41 supplies electrical power to the information processing units 50₁, 50₂, 50₃, ..., and includes a function of providing an interface.

Each of the information processing units 50₁, 50₂, 50₃, ... includes a server function similar to that of the computer device 10 (see Fig. 9).

Two of the information processing units 50₁, 50₂, 50₃, ... form one set. In Fig. 1, the information processing units 50₁ and 50₂ form one set.

The information processing unit 50₁ includes a storage unit 51₁ and a processor unit 54₁. The storage unit 51₁ and the processor unit 54₁ can be freely mounted and removed via a connector 53₁. The storage unit 51₁ includes an HDD 52A₁ and an HDD 52B₁ that are mounted on the same circuit board. The processor unit 54₁ includes a CPU 55A₁ and an HDD controller 56A₁ that are mounted on the same circuit board.

The information processing unit 50₂ includes a storage unit 51₂ and a processor unit 54₂. The storage unit 51₂ and the processor unit 54₂ can be freely mounted and removed via a connector 53₂. The storage unit 51₂ includes an HDD 52A₂ and an HDD 52B₂ that are mounted on the same circuit board. The processor unit 54₂ includes a CPU 55B₂ and an HDD controller 56B₂ that are mounted on the same circuit board.

In the information processing units 50₁ and 50₂, components represented by (A) in Fig. 1 (the HDD 52A₁, the HDD 52A₂, the CPU 55A₁, and the HDD controller 56A₁) form a group A. This group A corresponds to one computer device 10 (see Fig. 9) having a redundant configuration consisting of two HDDs.

In group A, the HDD controller 56A₁ controls writing to and reading from the HDD 52A₁ and the HDD 52A₂ which are large-capacity storage devices that store various types of data handled by the CPU 55A₁.

The HDD 52A₁ is connected to the HDD controller 56A₁ via the connector 53₁. The HDD 52A₂ is connected to the HDD controller 56A₁ via the connector 53₂, the processor unit 54₂, the connector 57₂, the back plane 41, and the connector 57₁.

The HDD 52A₁ and the HDD 52A₂ are mounted by dispersion in physically separate storage units (the storage units 51₁ and 51₂).

Components represented by (B) in Fig. 1 (the HDD 52B₁, the HDD 52B₂, the CPU 55B₂, and the HDD controller 56B₂) form a group B. This group B corresponds to one computer device 10 (see Fig. 9) having a redundant configuration consisting of two HDDs.

In group B, the HDD controller 56B₂ controls writing to and reading from the HDD 52B₁ and the HDD 52B₂ which are large-capacity storage devices that store various types of data handled by the CPU 55B₂.

The HDD 52B₁ is connected to the HDD controller 56B₂ via the connector 53₁, the processor unit 54₁, the connector 57₁, the back plane 41, and the connector 57₂. The HDD 52B₂ is connected to the HDD controller 56B₂ via the connector 53₂.

The HDD 52B₁ and the HDD 52B₂ are mounted by dispersion in physically separate storage units (the storage units 51₁ and 51₂).

A hot-swap method according to the first embodiment will be explained with reference to Figs. 3 to 5. An example in which the HDD 52A₂ breaks down and is hot-swapped without terminating the operation of the information processing units 50₁ and 50₂ will be explained with reference to Fig. 3.

In Fig. 3, when the HDD 52A₂ of the storage unit 51₂ in group A breaks down, data is recovered from the other HDD 52A₁ having the redundant configuration, thereby enabling continuous operation.

Due to the breakdown of the HDD 52A₂, the redundant configuration cannot be utilized in group A, and therefore the HDD 52A₂ is hot-swapped. As shown in Fig. 4, the storage unit 51₂ is removed as a whole and separated from the processor unit 54₂.

In group A, the HDD 52A₁ is currently used and is accessed by the CPU 55A₁ and the HDD controller 56A₁, whereby operation continues without being affected by the hot-swap.

Similarly in group B, the HDD 52B₁ is currently used and is accessed by the CPU 55B₂ and the HDD controller 56B₂, whereby operation continues without being affected by the hot-swap.

In the disconnected storage unit 51₂, the broken HDD 52A₂ is replaced with a replacement HDD 52A₂'.

As shown in Fig. 5, after this replacement, the storage unit 51₂ is mounted on the processor unit 54₂ via the connector 53₂. This restores the computer device 40 to its original state before breakdown.

As described above, according to the first embodiment, the HDDs 52A₁ and 52A₂ (storage devices) having a redundant configuration are mounted by physical dispersion, in a plurality of freely removable storage units 51₁ and 51₂ that form a part of the information processing units 50₁ and 50₂. Therefore, even if one HDD 52A₂ breaks down and the storage unit 51₂ is removed, the HDD controller 56A₁ can access the HDD 52A₁ provided in the other storage unit 51₁, so the HDDs having the redundant configuration can be hot-swapped in the information processing units 50₁ and 50₂.

While the first embodiment describes an example in which an HDD can be hot-swapped when there are two information processing units (information processing units 50₁ and 50₂) in one set, it is also possible to hot-swap an HDD when one set consists of three (or four or more) information processing units. An example of such a configuration is described below as a second embodiment.

Fig. 6 is a schematic plan view of the configuration according to the second embodiment of the present invention. In Fig. 6, like reference numerals designate like parts as those shown in Fig. 1.

A computer device 60 shown in Fig. 6 is a cluster server device (blade server device) in which a plurality of card-shaped information processing units 70₁, 70₂, 70₃, ... can be mounted in the casing 21.

The information processing units 70₁, 70₂, 70₃, ... can be freely inserted into and removed from slots 22₁, 22₂, 22₃, ... in the casing 21.

A back plane 78 is provided inside the casing 21, and is physically and electrically connected to the information processing units 70₁, 70₂, 70₃, ... via connectors 77₁, 77₂, 77₃, .... The back plane 78 supplies electrical power to the information processing units 70₁, 70₂, 70₃, ... and includes a function of providing an interface.

Each of the information processing units 70₁, 70₂, 70₃, ... includes a server function similar to that of the computer device 10 (see Fig. 9).

Three of the information processing units 70₁, 70₂, 70₃, ... form one set. In Fig. 6, the information processing units 70₁, 70₂, and 70₃ form one set.

The information processing unit 70₁ includes a storage unit 71₁ and a processor unit 74₁. The storage unit 71₁ and the processor unit 74₁ can be freely mounted and removed via a connector 73₁. The storage unit 71₁ includes an HDD 72A₁, an HDD 72B₁, and an HDD 72C₁, which are mounted on the same circuit board. The processor unit 74₁ includes a CPU 75A₁ and an HDD controller 76A₁ that are mounted on the same circuit board.

The information processing unit 70₂ includes a storage unit 71₂ and a processor unit 74₂. The storage unit 71₂ and the processor unit 74₂ can be freely mounted and removed via a connector 73₂. The storage unit 71₂ includes an HDD 72A₂, an HDD 72B₂, and an HDD 72C₂, which are mounted on the same circuit board. The processor unit 74₂ includes a CPU 75B₂ and an HDD controller 76B₂ that are mounted on the same circuit board.

The information processing unit 70₃ includes a storage unit 71₃ and a processor unit 74₃. The storage unit 71₃ and the processor unit 74₃ can be freely mounted and removed via a connector 73₃. The storage unit 71₃ includes an HDD 72A₃, an HDD 72B₃, and an HDD 72C₃, which are mounted on the same circuit board. The processor unit 74₃ includes a CPU 75C₃ and an HDD controller 76C₃ that are mounted on the same circuit board.

In the information processing units 70₁, 70₂, and 70₃, components represented by (A) in Fig. 6 (the HDD 72A₁, the HDD 72A₂, HDD 72A₃, the CPU 75A₁, and the HDD controller 76A₁) form a group A. This group A corresponds to one computer device 10 (see Fig. 9) having a redundant configuration consisting of three HDDs (n+1 redundant configuration).

In group A, the HDD controller 76A₁ controls writing to and reading from the HDD 72A₁, the HDD 72A₂, and the HDD 72A₃ which are large-capacity storage devices that store various types of data handled by the CPU 75A₁.

The HDD 72A₁ is connected to the HDD controller 76A₁ via the connector 73₁. The HDD 72A₂ is connected to the HDD controller 76A₁ via the connector 73₂, the processor unit 74₂, the connector 77₂, the back plane 78, and the connector 77₁.

The HDD 72A₃ is connected to the HDD controller 76A₁ via the connector 73₃, the processor unit 74₃, the connector 77₃, the back plane 78, and the connector 77₁.

The HDDs 72A₁, 72A₂, and 72A₃ are mounted by dispersion in physically separate storage units (the storage units 71₁, 71₂, and 71₃).

Similarly, components represented by (B) in Fig. 6 (the HDD 72B₁, the HDD 72B₂, the HDD 72B₃, the CPU 75B₂, and the HDD controller 76B₂) form a group B. This group B corresponds to one computer device 10 (see Fig. 9) having a redundant configuration consisting of three HDDs (n+1 redundant configuration).

In group B, the HDD controller 76B₂ controls writing to and reading from the HDD 72B₁, the HDD 72B₂, and the HDD 72B₃, which are large-capacity storage devices that store various types of data handled by the CPU 75B₂.

The HDD 72B₁ is connected to the HDD controller 76B₂ via the connector 73₁, the processor unit 74₁, the connector 77₁, the back plane 78, and the connector 77₂.

The HDD 72B₂ is connected to the HDD controller 76B₂ via the connector 73₂. The HDD 72B₃ is connected to the HDD controller 76B₂ via the connector 73₃, the processor unit 74₃, the connector 77₃, the back plane 78, and the connector 77₂.

The HDDs 72B₁, 72B₂, and 72B₃ are mounted by dispersion in physically separate storage units (the storage units 71₁, 71₂, and 71₃).

Similarly, components represented by (C) in Fig. 6 (the HDD 72C₁, the HDD 72C₂, the HDD 72C₃, the CPU 75C₃, and the HDD controller 76C₃) form a group C. This group C corresponds to one computer device 10 (see Fig. 9) having a redundant configuration consisting of three HDDs (n+1 redundant configuration).

In group C, the HDD controller 76C₃ controls writing to and reading from the HDD 72C₁, the HDD 72C₂, and the HDD 72C₃ which are large-capacity storage devices that store various types of data handled by the CPU 75C₃.

The HDD 72C₁ is connected to the HDD controller 76C₃ via the connector 73₁, the processor unit 74₁, the connector 77₁, the back plane 78, and the connector 77₃.

The HDD 72C₂ is connected to the HDD controller 76C₃ via the connector 73₂, the processor unit 74₂, the connector 77₂, the back plane 78, and the connector 77₃.
The HDD 72C₃ is connected to the HDD controller 76C₃ via the connector 73₃.

The HDDs 72C₁, 72C₂, and 72C₃ are mounted by dispersion in physically separate storage units (the storage units 71₁, 71₂, and 71₃).

A hot-swap method according to the second embodiment will be explained with reference to Figs. 6 to 8. An example in which the HDD 72A₂ breaks down and is hot-swapped without terminating the operation of the information processing units 70₁, 70₂, and 70₃ as shown in Fig. 6 will be explained.

In Fig. 6, when the HDD 72A₂ of the storage unit 71₂ in group A breaks down, data is recovered from another HDD 72A₁ (or HDD 72A₃) having the redundant configuration, thereby enabling continuous operation.

In group A, the HDD 72A₂ is hot-swapped due to breakdown. As shown in Fig. 7, the storage unit 71₂ is removed as a whole and separated from the processor unit 74₂.

In group A, the HDD 72A₁ (or HDD 72A₃) is currently used and is accessed by the CPU 75A₁ and the HDD controller 76A₁, whereby operation continues without being affected by the hot-swap.

Similarly, in group B, the HDD 72B₁ (or HDD 72B₃) is currently used and is accessed by the CPU 75B₂ and the HDD controller 76B₂, whereby operation continues without being affected by the hot-swap.

Similarly, in group C, the HDD 72C₁ (or HDD 72C₃) is currently used and is accessed by the CPU 75C₃ and the HDD controller 76C₃, whereby operation continues without being affected by the hot-swap.

In the disconnected storage unit 71₂, the broken HDD 72A₂ is replaced with a replacement HDD 72A₂'.

As shown in Fig. 8, after this replacement, the storage unit 71₂ is mounted in the processor unit 74₂ via the connector 73₂. This restores the computer device 60 to its original state before breakdown.

As described above, the second embodiment achieves the same effects as the first embodiment.

As explained above, according to the present invention, a plurality of storage devices having a redundant configuration are mounted by physical dispersion in a plurality of information processing units. Therefore, even if an information processing unit is removed when one of its storage devices breaks down, a controller can access a storage device mounted in another information processing unit, and the storage device having the redundant configuration can be hot-swapped in the information processing units.

According to the present invention, a plurality of storage devices having a redundant configuration are mounted by physical dispersion in a plurality of freely removable storage units that form a part of a plurality of information processing units. Therefore, even if one of the storage devices breaks down and the storage unit is removed, a controller can access a storage device mounted in another storage unit, thereby enabling the storage device having the redundant configuration to be hot-swapped in the information processing units.

According to the present invention, since the information processing units have a server function, a storage device having a redundant configuration can be hot-swapped in a server having a plurality of information processing units.

According to the present invention, when a storage device that is removably mounted in an information processing unit cannot be used, a storage device mounted in another information processing unit is used instead, thereby making it possible to hot-swap the storage device that cannot be used.

### INDUSTRIAL APPLICABILITY

As described above, the computer device and the cluster server device according to the present invention are useful in hot-swapping storage devices that have a redundant configuration, and that are installed in a plurality of information processing units.

## Claims

1. A computer device (40, 60) comprising:
a plurality of information processing units (50₁, 50₂, 50₃, 70₁, 70₂, 70₃) configured to execute respective information processing functions;
a plurality of storage devices (52A₁, 52B₁, 52A₂, 52B₂, 72A₁, 72B₁, 72C₁, 72A₂, 72B₂, 72C₂, 72A₃, 72B₃, 72C₃) physically dispersed in the information processing units (50₁, 50₂, 50₃, 70₁, 70₂, 70₃), wherein each information processing unit (50₁, 50₂, 50₃, 70₁, 70₂, 70₃) includes at least two storage devices (52A₁, 52B₁, 52A₂, 52B₂, 72A₁, 72B₁, 72C₁, 72A₂, 72B₂, 72C₂, 72A₃, 72B₃, 72C₃) and each information processing unit (50₁, 50₂, 50₃, 70₁, 70₂, 70₃) includes a controller (56A₁, 56B₂, 76A₁, 76B₂, 76C₃) configured to access the storage devices (52A₁, 52B₁, 52A₂, 52B₂, 72A₁, 72B₁, 72C₁, 72A₂, 72B₂, 72C₂, 72A₃, 72B₃, 72C₃);
**characterized in that**
the information processing units (50₁, 50₂, 50₃, 70₁, 70₂, 70₃) are grouped into sets,
in each set, each controller (56A₁, 56B₂, 76A₁, 76B₂, 76C₃) respectively accesses one storage device (52A₁, 52B₁, 52A₂, 52B₂, 72A₁, 72B₁, 72C₁, 72A₂, 72B₂, 72C₂, 72A₃, 72B₃, 72C₃) in each information processing unit (50₁, 50₂, 50₃, 70₁, 70₂, 70₃) included in the set, said storage devices (52A₁, 52B₁, 52A₂, 52B₂, 72A₁, 72B₁, 72C₁, 72A₂, 72B₂, 72C₂, 72A₃, 72B₃, 72C₃) accessed by one controller (56A₁, 56B₂, 76A₁, 76B₂, 76C₃) having a redundant configuration,
the number of information processing units (50₁, 50₂, 50₃, 70₁, 70₂, 70₃) in one set is equal to a number of storage devices (52A₁, 52B₁, 52A₂, 52B₂, 72A₁, 72B₁, 72C₁, 72A₂, 72B₂, 72C₂, 72A₃, 72B₃, 72C₃) accessible to the controller (56A₁, 56B₂, 76A₁, 76B₂, 76C₃) and
the storage devices (52A₁, 52B₁, 52A₂, 52B₂, 72A₁, 72B₁, 72C₁, 72A₂, 72B₂, 72C₂, 72A₃, 72B₃, 72C₃) included in a processing unit (50₁, 50₂, 50₃, 70₁, 70₂, 70₃) are simultaneously removable.

2. The computer device (40, 60) according to claim 1,
wherein the information processing units (50₁, 50₂, 50₃, 70₁, 70₂, 70₃) include at least a first information processing unit (50₁) and a second information processing unit (50₂), and when a storage device (52A₁, 52B₁) in the first information processing unit (50₁) is unusable, the respective controller (56A₁, 56B₂) uses a storage device (52A₂, 52B₂) in the second information processing unit (50₂) having a configuration redundant to the unusable storage device (52A₁, 52B₁) in the first information processing unit (50₁).

3. The computer device (40, 60) according to claim 1,
wherein each of the plurality of information processing units (50₁, 50₂, 50₃, 70₁, 70₂, 70₃) functions as a server.

## Patentansprüche

1. Ein Computersystem (40, 60) aufweisend:
eine Vielzahl an Informationsverarbeitungseinheiten (50₁, 50₂, 50₃, 70₁, 70₂, 70₃) die konfiguriert sind um entsprechende Informationsverarbeitungsfunktionen auszuführen;
eine Vielzahl an Speichereinheiten (52A₁, 52B₁, 52A₂, 52B₂, 72A₁, 72B₁, 72C₁, 72A₂, 72B₂, 72C₂, 72A₃, 72B₃, 72C₃) die physikalisch auf die Informationsverarbeitungseinheiten (50₁, 50₂, 50₃, 70₁, 70₂, 70₃) aufgeteilt sind, wobei jede Informationsverarbeitungseinheit (50₁, 50₂, 50₃, 70₁, 70₂, 70₃) zumindest zwei Speichereinheiten (52A₁, 52B₁, 52A₂, 52B₂, 72A₁, 72B₁, 72C₁, 72A₂, 72B₂, 72C₂, 72A₃, 72B₃, 72C₃) beinhaltet und jede Informationsverarbeitungseinheit (50₁, 50₂, 50₃, 70₁, 70₂, 70₃) einen Kontroller (56A₁, 56B₂, 76A₁, 76B₂, 76C₃) beinhaltet, der konfiguriert ist um auf die Speichereinheiten (52A₁, 52B₁, 52A₂, 52B₂, 72A₁, 72B₁, 72C₁, 72A₂, 72B₂, 72C₂, 72A₃, 72B₃, 72C₃) zuzugreifen;
**dadurch gekennzeichnet,**
**dass** die Informationsverarbeitungseinheiten (50₁, 50₂, 50₃, 70₁, 70₂, 70₃) in Sets gruppiert sind,
in jedem Set jeder Kontroller (56A₁, 56B₂, 76A₁, 76B₂, 76C₃) jeweils auf eine Speichereinheit (52A₁, 52B₁, 52A₂, 52B₂, 72A₁, 72B₁, 72C₁, 72A₂, 72B₂, 72C₂, 72A₃, 72B₃, 72C₃) in jeder zu dem Set gehörigen Informationsverarbeitungseinheit (50₁, 50₂, 50₃, 70₁, 70₂, 70₃) zugreifen kann, wobei die Speichereinheiten (52A₁, 52B₁, 52A₂, 52B₂, 72A₁, 72B₁, 72C₁, 72A₂, 72B₂, 72C₂, 72A₃, 72B₃, 72C₃), auf die durch einen Kontroller (56A₁, 56B₂, 76A₁, 76B₂, 76C₃) zugegriffen werden kann, eine redundante Konfiguration haben,
die Anzahl an Informationsverarbeitungseinheiten (50₁, 50₂, 50₃, 70₁, 70₂, 70₃) in einem Set gleich der Anzahl an Speichereinheiten (52A₁, 52B₁, 52A₂, 52B₂, 72A₁, 72B₁, 72C₁, 72A₂, 72B₂, 72C₂, 72A₃, 72B₃, 72C₃) ist, auf die der Kontroller (56A₁, 56B₂, 76A₁, 76B₂, 76C₃) zugreifen kann und
die Speichereinheiten (52A₁, 52B₁, 52A₂, 52B₂, 72A₁, 72B₁, 72C₁, 72A₂, 72B₂, 72C₂, 72A₃, 72B₃, 72C₃), die zu einer Verarbeitungseinheit (50₁, 50₂, 50₃, 70₁, 70₂, 70₃) gehören, gleichzeitig entfernt werden können.

2. Das Computersystem (40, 60) nach Anspruch 1,
wobei die Informationsverarbeitungseinheiten (50₁, 50₂, 50₃, 70₁, 70₂, 70₃) zumindest eine erste Informationsverarbeitungseinheit (50₁) und eine zweite Informationsverarbeitungseinheit (50₂) beinhalten, und, wenn eine Speichereinheit (52A₁, 52B₁) in der ersten Informationsverarbeitungseinheit (50₁) ausfällt, der entsprechende Kontroller (56A₁, 56B₂) eine Speichereinheit (52A₂, 52B₂) in der zweiten Informationsverarbeitungseinheit (52₂) benutzt, die eine redundante Konfiguration bezüglich der ausgefallenen Speichereinheit (52A₁, 52B₁) in der ersten Informationsverarbeitungseinheit (50₁) hat.

3. Das Computersystem (40, 60) nach Anspruch 1,
wobei jede der Vielzahl an Informationsverarbeitungseinheiten (50₁, 50₂, 50₃, 70₁, 70₂, 70₃) als ein Server arbeitet.

## Revendications

1. Dispositif informatique (40, 60) comprenant :
une pluralité d'unités de traitement d'informations (50₁, 50₂, 50₃, 70₁, 70₂, 70₃) configurées pour exécuter des fonctions de traitement d'informations respectives ;
une pluralité de dispositifs de stockage (52A₁, 52B₁, 52A₂, 52B₂, 72A₁, 72B₁, 72C₁, 72A₂, 72B₂, 72C₂, 72A₃, 72B₃, 72C₃) dispersés physiquement dans les unités de traitement d'informations (50₁, 50₂, 50₃, 70₁, 70₂, 70₃) , où chaque unité de traitement d'informations (50₁, 50₂, 50₃, 70₁, 70₂, 70₃) inclut au moins deux dispositifs de stockage (52A₁, 52B₁, 52A₂, 52B₂, 72A₁, 72B₁, 72C₁, 72A₂, 72B₂, 72C₂, 72A₃, 72B₃, 72C₃) et chaque unité de traitement d'informations (50₁, 50₂, 50₃, 70₁, 70₂, 70₃) inclut un contrôleur (56A₁, 56B₂, 76A₁, 76B₂, 76C₃) configuré pour accéder aux dispositifs de stockage (52A₁, 52B₁, 52A₂, 52B₂, 72A₁, 72B₁, 72C₁, 72A₂, 72B₂, 72C₂, 72A₃, 72B₃, 72C₃ ) ;
**caractérisé en ce que**
les unités de traitement d'informations (50₁, 50₂, 50₃, 70₁, 70₂, 70₃) sont groupées en ensembles,
dans chaque ensemble, chaque contrôleur (56A₁, 56B₂, 76A₁, 76B₂, 76C₃) accède respectivement à un dispositif de stockage (52A₁, 52B₁, 52A₂, 52B₂, 72A₁, 72B₁, 72C₁, 72A₂, 72B₂, 72C₂, 72A₃, 72B₃, 72C₃) dans chaque unité de traitement d'informations (50₁, 50₂, 50₃, 70₁, 70₂, 70₃) incluse dans l'ensemble, lesdits dispositifs de stockage (52A₁, 52B₁, 52A₂, 52B₂, 72A₁, 72B₁, 72C₁, 72A₂, 72B₂, 72C₂, 72A₃, 72B₃, 72C₃) ayant fait l'objet d'un accès par un contrôleur (56A₁, 56B₂, 76A₁, 76B₂, 76C₃) ayant une configuration redondante,
le nombre d'unités de traitement d'informations (50₁, 50₂, 50₃, 70₁, 70₂, 70₃) dans un ensemble est égal à un nombre de dispositifs de stockage (52A₁, 52B₁, 52A₂, 52B₂, 72A₁, 72B₁, 72C₁, 72A₂, 72B₂, 72C₂, 72A₃, 72B₃, 72C₃) accessibles au contrôleur (56A₁, 56B₂, 76A₁, 76B₂, 76C₃) et
les dispositifs de stockage (52A₁, 52B₁, 52A₂, 52B₂, 72A₁, 72B₁, 72C₁, 72A₂, 72B₂, 72C₂, 72A₃, 72B₃, 72C₃) inclus dans une unité de traitement (50₁, 50₂, 50₃, 70₁, 70₂, 70₃) sont amovibles simultanément.

2. Dispositif informatique (40, 60) selon la revendication 1,
dans lequel les unités de traitement d'informations (50₁, 50₂, 50₃, 70₁, 70₂, 70₃) incluent au moins une première unité de traitement d'informations (50₁) et une seconde unité de traitement d'informations (50₂), et lorsqu'un dispositif de stockage (52A₁, 52B₁) dans la première unité de traitement d'informations (50₁) est inutilisable, le contrôleur respectif (56A₁, 56B₂) utilise un dispositif de stockage (52A₂, 52B₂) dans la seconde unité de traitement d'informations (50₂) ayant une configuration redondante par rapport à celle du dispositif de stockage inutilisable (52A₁, 52B₁) dans la première unité de traitement d'informations (50₁).

3. Dispositif informatique (40, 60) selon la revendication 1,
dans lequel chacune de la pluralité d'unités de traitement d'informations (50₁, 50₂, 50₃, 70₁, 70₂, 70₃) fonctionne comme un serveur.
